# EUROPÄISCHE PATENTSCHRIFT

(11) **EP 1 989 340 B1**
(45) Veröffentlichungstag und Bekanntmachung des Hinweises auf die Patenterteilung: **25.08.2010**
(21) Anmeldenummer: 07703478.3
(22) Anmeldetag: 14.02.2007
(51) Int. Cl.: C23C 14/34

(54) **TARGETANORDNUNG**
TARGET ARRANGEMENT
SYSTÈME CIBLE

(30) Priorität: 02.03.2006 DE 102006009749
(43) Veröffentlichungstag der Anmeldung: 12.11.2008
(73) Patentinhaber: GfE Fremat GmbH, 09599 Freiberg (DE)
(72) Erfinder: HÜTTL, Grit, 09599 Freiberg (DE); STEINERT, Folke, 09599 Freiberg (DE); WAGNER, Joachim, 09599 Freiberg (DE)
(74) Vertreter: Manitz, Gerhart
(86) Internationale Anmeldenummer: PCT/EP2007/001295
(87) Internationale Veröffentlichungsnummer: WO 2007/098858

(56) Entgegenhaltungen:
- EP-A- 1 561 836
- WO-A-2006/063721
- DE-A1- 10 231 203
- DE-A1- 10 252 577
- DE-A1-102005 020 250
- JP-A- 8 060 351
- JP-A- 63 270 460
- US-A- 5 653 856

## Beschreibung

Die Erfindung betrifft eine Targetanordnung mit einem rohrförmigen Trägerelement und einem mindestens ein Targetmaterial aufweisenden hohlzylindrischen Target, welches wenigstens ein einstückig ausgebildetes und das Trägerelement zumindest abschnittsweise umgebendes Rohrsegment umfasst.

Derartige Targetanordnungen, die auch als Zerstäubungstargets oder Sputtertargets bezeichnet werden, sind grundsätzlich bekannt. Sie werden als Materialquelle beispielsweise bei der Dünnbeschichtung von großflächigen Substraten mittels Kathodenzerstäubung oder Sputtern eingesetzt. Die Dünnbeschichtung mittels solcher Targetanordnungen wird beispielsweise für die Herstellung von Wärmeschutz- oder Sonnenschutzschichten auf Flachglas oder Kunststofffolien angewandt.

Problematisch gestaltet sich bei Targetanordnungen der eingangs genannten Art die Befestigung des Targets am Trägerelement. Dies gilt insbesondere für solche Targetanordnungen, bei denen das Target nicht direkt durch einen Gießprozess oder ein thermisches Spritzverfahren auf das Trägerelement aufgebracht ist, beispielsweise weil das Targetmaterial beim Gießen oder thermischen Spritzen sublimieren würde.

So sind Targetanordnungen bekannt, bei denen das Target mit Hilfe von elastischen Klemmelementen kraftschlüssig an dem Trägerelement befestigt ist. Mittels einer derartigen kraftschlüssigen Verbindung wird jedoch nur eine mäßige Wärmeableitung zwischen Target und Trägerelement erreicht.

Eine verbesserte Wärmeableitung könnte durch eine vollflächige stoffschlüssige Verbindung zwischen Target und Trägerelement erreicht werden. Derartige vollflächige stoffschlüssige Verbindungen kommen zum Beispiel bei Planartargets zum Einsatz, bei denen ein planares Targetsegment mittels einer durchgängigen Lotschicht an einer Trägerplatte befestigt wird. Entsprechend lässt sich auf diese Weise ein halbzylindrisches Targetsegment an einem rohrförmigen Trägerelement anbringen.

Für Targetanordnungen, bei denen das Target aus wenigstens einem Rohrsegment gebildet ist, sind vollflächige stoffschlüssige Lotverbindungen jedoch nicht geeignet. Da die Trägerelemente rohrförmiger Targetanordnungen beispielsweise ein metallisches Material und die Targetrohrsegmente ein Keramikmaterial aufweisen, besitzen die Trägerelemente und die Rohrsegmente signifikant voneinander abweichende thermische Expansionskoeffizienten. Aufgrund des resultierenden Unterschiedes in der Wärmedehnung von Trägerelement und Rohrsegment und wegen der Sprödigkeit des Keramikmaterials besteht nicht nur die Gefahr einer Lockerung der Verbindung zwischen Trägerelement und Rohrsegment, sondern auch die Gefahr einer Beschädigung der Rohrsegmente.

Um die unterschiedlichen Expansionskoeffizienten zwischen Metall- und Keramikmaterial zu kompensieren, wurde auch eine Verklebung von Trägerelement und Rohrsegment mittels eines plastisch verformbaren Klebstoffes in Erwägung gezogen. Abgesehen davon, dass ein derartiger Klebstoff nicht über ausreichend hohe Wärmeleitungseigenschaften verfügt, erfordert eine zuverlässige Verklebung zweier Fügepartner außerdem das Aufbringen eines gewissen Drucks auf die Fügepartner. Eine Verklebung von Trägerelement und Targetsegment mag daher für Targetanordnungen mit planaren oder halbzylindrischen Targetsegmenten in Frage kommen. Aufgrund der Steifigkeit sowohl des Rohrsegments als auch des Trägerelements und wegen der koaxialen Anordnung von Trägerelement und Rohrsegment lässt sich ein zwischen Trägerelement und Rohrsegment eingebrachter Klebstoff in radialer Richtung gesehen jedoch nicht beaufschlagen. Eine Verklebung von Trägerelement und Targetsegment ist bei Targetanordnungen mit rohrförmigen Targetsegmenten in der Praxis daher kaum zu realisieren.

EP-A-1561836 offenbart ein Verfahren zur Herstellung einer Targetanordnung, in dem ein hohlzylindrisches keramisches Target (22, 24) und rohrförmiges Trägerelement durch plastisch verformbare Ausgleichsmittel partiell stoffschlüssig miteinander verbunden werden.

US5653856 offenbart eine Targetanordnung mit einem ITO Rohrtarget mit einer Beschichtung und einer Schichtfolge aus Nickel, Kupfer und Weichlot zwischen Trägerelement und Target.

Der Erfindung liegt die Aufgabe zugrunde, eine Targetanordnung der eingangs genannten Art zu schaffen, bei der das Trägerelement und das Target auf einfache und zuverlässige Weise miteinander verbunden sind und gleichzeitig ein verbesserter Wärmeübergang zwischen Target und Trägerelement gewährleistet ist.

Die Aufgabe wird erfindungsgemäß durch eine Targetanordnung mit den Merkmalen des Anspruchs 1 gelöst, sowie ein Verfarhren nach Anspruch 9 und ein Rohrsegment nach Anspruch 13.

Da das Trägerelement und das Rohrsegement bzw. die Rohrsegmente des Targets erfindungsgemäß nicht in direktem Kontakt miteinander stehen, sondern durch plastisch verformbare Ausgleichsmittel miteinander verbunden sind, können sich die Fügepartner, d.h. das Trägerelement und das Target, im Falle einer Erwärmung, beispielsweise während eines Sputtervorgangs, gemäß ihren unterschiedlichen thermischen Expansionskoeffizienten verschieden stark ausdehnen, ohne dass dabei Spannungen in

dem Targetmaterial hervorgerufen würden, die zu einer Beschädigung des Targets, z.B. zu Rissen in dem Targetmaterial, führen könnten. Durch die plastisch verformbaren Ausgleichsmittel werden unterschiedliche Wärmedehnungen von Trägerelement und Target gewissermaßen ausgeglichen bzw. kompensiert.

Gleichzeitig wird durch die stoffschlüssige Verbindung der Ausgleichsmittel sowohl mit dem Target als auch mit dem Trägerelement ein im Vergleich zu kraftschlüssigen Fügevarianten verbesserter Wärmeübergang zwischen Target und Trägerelement erreicht. So kann die während eines Sputtervorgangs in das Target eingebrachte Wärme über die stoffschlüssige Verbindung bis zu zehnmal besser an das Trägerelement abgeleitet werden als durch eine kraftschlüssige Verbindung.

Dies erlaubt einen Einsatz der Targetanordnung in so genannten Hochleistungssputterprozessen, d.h. also eine Verwendung der Targetanordnung beim Sputtern mit erhöhten Leistungsdichten und insbesondere erhöhten Spannungen. Darüber hinaus ermöglicht die stoffschlüssige Anbindung auch eine erhöhte Targetausnutzung von bis zu 80 %, da nicht die Gefahr besteht, dass Teile des Targets bei zu geringer Restdichte im Falles eines dadurch begründeten Versagens in die Sputteranlage geraten können. Beides resultiert letztlich in einer verbesserten Wirtschaftlichkeit des jeweiligen Sputterverfahrens.

Der Ausdruck "partiell miteinander verbunden" ist hier so zu verstehen, dass das Trägerelement und das Rohrsegment nicht vollflächig, sondern lediglich bereichsweise miteinander verbunden sind. Ein zwischen dem Rohrsegment und dem Trägerelement befindlicher Spalt ist also nicht vollständig durch die Ausgleichsmittel ausgefüllt. Vielmehr stellen die Ausgleichsmittel eine partielle Verbindung zwischen dem Trägerelement und dem Target her, d.h. sie bilden voneinander getrennte, lokal begrenzte Brücken zwischen den Fügepartnern. Dadurch ist die Verformbarkeit der Ausgleichsmittel erheblich erhöht, und die unterschiedliche Wärmedehnung von Target und Trägerelement kann besonders wirksam kompensiert werden.

Vorteilhafte Ausbildungen der Erfindung sind den Unteransprüchen, der Beschreibung und der Zeichnung zu entnehmen.

Gemäß einer bevorzugten Ausführungsform sind die Ausgleichsmittel flussmittelfrei. Dadurch eignet sich die Targetanordnung besonders gut für die Verwendung in einer Vakuumanlage, in welcher grundsätzlich die Gefahr eines Ausdampfens von flüchtigen Stoffen, wie beispielsweise Flußmitteln, besteht.

Besonders vorteilhaft ist es, wenn die Ausgleichsmittel ein Lot und insbesondere ein Weichlot umfassen. Lot besitzt nicht nur eine besonders hohe thermische Leitfähigkeit, sondern es ist auch besonders gut plastisch verformbar. Ferner besitzt z.B. ein Sn-Lot einen Wärmeausdehnungskoeffizienten von etwa 24·10⁻⁶ K⁻¹, wohingegen ZnO einen Wärmeausdehnungskoeffizienten von etwa 5,3·10⁻⁶ K⁻¹ und Edelstahl einen Wärmeausdehnungskoeffizienten von etwa 16·10⁻⁶ K⁻¹ aufweist. Sn-Lot aufweisende Ausgleichsmittel können folglich die unterschiedlichen Wärmedehnungen eines ZnO-Targets und eines Edelstahl-Trägerelements besonders wirksam kompensieren. Darüber hinaus lässt sich Lot besonders leicht verarbeiten, wodurch die Herstellung der Targetanordnung insgesamt vereinfacht ist.

Des Weiteren lässt sich Lot unter entsprechender Wärmezufuhr wieder verflüssigen, wodurch es möglich ist, die Verbindung zwischen den Fügepartnern zu trennen und das Target von dem Trägerelement zu lösen. Ein beschädigtes Rohrsegment lässt sich somit auf einfache Weise durch ein unbeschädigtes Rohrsegment ersetzen. Die Trennung von Target und Trägerelement erlaubt außerdem eine Wiederverwendung des Trägerelements nachdem das Targetmaterial in einem Sputtervorgang oder in mehreren Sputtervorgängen verbraucht wurde.

Zueinander beabstandete Bereiche eines zwischen dem Target und dem Trägerelement vorgesehenen Spalts sind mit Lot ausgefüllt. Die Ausgleichsmittel sind also durch voneinander getrennte, lokal begrenzte Lotbrücken gebildet, welche das Target und das Trägerelement partiell miteinander verbinden. Die Lotbrücken weisen eine besondere gute Verformbarkeit auf, wodurch wärmeinduzierte Spannungen zwischen Target und Trägerelement noch besser ausgeglichen werden können.

Besonders vorteilhaft ist es, wenn das Lot zwischen dem Target und Vorsprüngen des Trägerelements vorgesehen ist. Durch die Vorsprünge sind Bereiche vorgegeben, in denen das Lot die Fügepartner miteinander verbindet.

Vorzugsweise sind die Vorsprünge in axialer oder radialer Richtung gesehen zueinander beabstandet und insbesondere über die dann in radialer oder axialer Richtung gesehen im Wesentlichen gesamte Länge des Targets verteilt angeordnet. Dadurch können zum einen in axialer Richtung unterschiedliche Wärmedehnungen der Fügepartner besonders gut kompensiert werden. Zum anderen kann eine thermische Ankopplung des Targets an das Trägerelement über die gesamte Länge des Targets sichergestellt werden. Vorteilhafterweise umfassen die Vorsprünge im Wesentlichen in Umfangsrichtung des Trägerelements verlaufende Stege. Derartige Vorsprünge lassen sich besonders einfach herstellen, beispielsweise durch entsprechendes Einbringen, z.B. Einfräsen oder Einschneiden, von länglichen Aussparungen oder Nuten in das Trägerelement.

Gemäß einer Ausführungsform erstrecken sich mehrere stegartige Vorsprünge rechtwinklig zur Längsachse des Trägerelements. Bevorzugt erstrecken sich die Vorsprünge dabei ringartig über den gesamten Umfang des Trägerelements. Alternativ oder zusätzlich kann ein stegartiger Vorsprung spiralförmig um das Trägerelement herum verlaufen. Ein derartiger Vorsprung lässt sich zum Beispiel dadurch ausbilden, dass eine spiralförmige Aussparung nach Art einer Gewindenut in das Trägerelement geschnitten wird. Sowohl die ringartigen Vorsprünge als auch die spiralförmigen Vorsprünge ermöglichen auf einfache Weise die Herstellung beliebig langer Targetanordnungen.

Vorteilhafterweise bilden durch die Vorsprünge begrenzte Aussparungen des Trägerelements in einem Vormontagezustand der Targetanordnung einen Aufnahmeraum für das Lot. Bei der Montage der Targetanordnung braucht das Lot also nicht gezielt auf die Vorsprünge aufgebracht zu werden, sondern es kann, beispielsweise in Form eines Halbzeugs, in den Aussparungen angeordnet werden. Die Aussparungen bilden somit gewissermaßen ein Reservoir für das Lot. Die Herstellung der Targetanordnung wird dadurch noch weiter vereinfacht.

Vorzugsweise sind Fixiermittel zwischen dem Rohrsegment und dem Trägerelement angeordnet, um das Target in einem Vormontagezustand bezüglich des Trägerelements zu fixieren und insbesondere zu zentrieren. Noch bevor das Target und das Trägerelement durch das Lot stoffschlüssig miteinander verbunden sind, wird durch die Fixiermittel also eine korrekte Positionierung der Fügepartner relativ zueinander sichergestellt. Dies erleichtert zum einen die Herstellung der Targetanordnung und gewährleistet zum anderen einen korrekten Sitz des Targets auf dem Trägerelement.

Alternativ kann das Target unter Ausnutzung der unterschiedlichen Wärmedehnungen von Target und Trägerelement auch ohne Fixiermittel bezüglich des Trägerelements zentriert werden.

Gemäß einer zur Erfindung alternativen Ausführungsform umfassen die Ausgleichsmittel jeweils ein Federelement. Die Verbindung von Trägerelement und Target erfolgt bei dieser Fügevariante also nicht über Lotbrücken, sondern über stoffschlüssig mit dem Trägerelement und dem Target verbundene Federelemente. Diese Fügevariante vereint die Vorteile einer kraftschlüssigen Verbindung mit denen einer stoffschlüssigen Verbindung. So wird durch die Elastizität der Federelemente ein besonders guter Ausgleich zwischen den unterschiedlichen Expansionskoeffizienten des Trägerelements und des Targets und durch die stoffschlüssige Anbindung der Federelemente sowohl an das Trägerelement als auch an das Target eine besonders effiziente Wärmeableitung von dem Target an das Trägerelement erreicht.

Vorteilhafterweise ist jedes Federelement mittels eines Lotes, insbesondere Weichlotes, stoffschlüssig mit dem Trägerelement und mit dem Rohrsegment verbunden. Wie vorstehend bereits erwähnt wurde, besitzt Lot besonders gute Wärmeleitungseigenschaften, so dass die thermische Ankopplung des Targets an das Trägerelement noch weiter verbessert ist.

An der Außenseite des Trägerelements können Aussparungen für die Federelemente vorgesehen sein. Durch die Aussparungen sind die Federelemente bereits in einem Vormontagezustand an dem Trägerelement fixiert und insbesondere gegen eine axiale Verschiebung bezüglich des Trägerelements gesichert. Dies erleichtert das Aufschieben des Rohrsegmentes bzw. der Rohrsegmente auf das Trägerelement.

Gemäß einer weiteren Ausführungsform ist das Target an seiner Innenseite und/oder das Trägerelement an seiner Außenseite, insbesondere ganzflächig, metallisiert. Eine derartige Metallisierung stellt eine besonders zuverlässige stoffschlüssige Verbindung zwischen den Fügepartnern sicher, insbesondere wenn ein flussmittelfreies Weichlot als Ausgleichsmittel oder als Verbindungsmittel zur Verbindung von Federelementen mit dem Target und dem Trägerelement verwendet wird und das Target aus einem Keramikmaterial, wie z.B. ZnO, besteht. Das Target kann an seiner Innenseite beispielsweise galvanisch beschichtet und das Trägerelement an seiner Außenseite belotet sein.

Um zu verhindern, dass beim Herstellen der stoffschlüssigen Verbindung von Target und Trägerelement aufgeschmolzenes Lot an die Außenseite des Targets dringt, kann zwischen zwei benachbarten Rohrsegmenten jeweils ein, insbesondere hitzbeständiges, Dichtmaterial, z.B. ein Silikonmaterial, vorgesehen sein.

Weiterer Gegenstand der Erfindung ist außerdem ein Verfahren mit den Merkmalen des Anspruchs 9. Durch das erfindungsgemäße Verfahren werden die voranstehend genannten Vorteile entsprechend erreicht.

Gemäß einer Ausführungsform des erfindungsgemäßen Verfahrens werden das Trägerelement und das Rohrsegment mittels eines Lotes, insbesondere eines Weichlotes und bevorzugt mittels eines flussmittelfreien Weichlotes miteinander verbunden.

Bevorzugt wird das Lot in einem Vormontagezustand der Targetanordnung zwischen zueinander beabstandeten und insbesondere stegartig ausgebildeten Vorsprünge des Trägerelements angeordnet. Dies stellt eine besonders einfache Methode zur Aufbringung des Lotes auf das Trägerelement dar. Das Lot kann beispielsweise als Halbzeug in die zwischen den Vorsprüngen ausgebildeten Aussparungen eingelegt werden.

Damit das Lot eine stoffschlüssige Verbindung zwischen Trägerelement und Target herstellen kann, muss es verflüssigt werden. Dabei ist es besonders vorteilhaft, wenn das Target und das Trägerelement derart rotiert werden, dass sich das verflüssigte Lot unter Einwirkung von Zentrifugal- und Kapillarkräften in zwischen dem Target und Vorsprüngen des Trägerelements ausgebildete Spalte hineinbewegt, um das Target und das Trägerelement zu kontaktieren.

Durch die Rotation von Target und Trägerelement bewegt sich das verflüssigte Lot also aus einer Vormontagelage in eine Endlage, nämlich aus den Aussparungen in die zwischen den Vorsprüngen und dem Target ausgebildeten Spalte. Sobald sich so viel Lot auf die Vorsprünge hinauf bewegt hat, dass die Spalte zwischen den Vorsprüngen und dem Target vollständig mit Lot gefüllt sind, können der Wärmeeintrag und die Rotation der Targetanordnung beendet werden, damit das Lot erkalten und sich sowohl mit dem Target als auch mit den Vorsprüngen des Trägerelements stoffschlüssig verbinden kann.

Dadurch, dass sich das Lot aufgrund der Zentrifugal- und Kapillarkräfte in die Spalte zwischen den Vorsprüngen und dem Target hineinbewegt, wird selbsttätig eine korrekte Positionierung des Lotes in den für die stoffschlüssige Verbindung von Target und Trägerelement vorgesehenen Bereichen erreicht. Dies vereinfacht die Herstellung der Targetanordnung und ermöglicht die Herstellung von beliebig langen Targetanordnungen. Dabei ist es nicht erforderlich, das Lot gleichzeitig über die gesamte Länge der Targetanordnung aufzuschmelzen bzw. erstarren zu lassen, sondern die Targetanordnung kann zum Verflüssigen des Lotes durch eine entsprechend ausgebildeten Wärmequelle, z.B. einen Durchlaufofen, hindurch bewegt werden.

Gemäß einer Ausführungsform eines anderen Verfahrens umfasst jedes Ausgleichsmittel ein Federelement, welches durch Lot mit dem Trägerelement und dem Rohrsegment verbunden wird. Durch einen entsprechenden Wärmeeintrag ist es möglich das zwischen den Federelementen und dem Trägerelement befindliche Lot und das zwischen den Federelementen und dem Target befindliche Lot gleichzeitig aufzuschmelzen, um die stoffschlüssige Verbindung der Federelemente mit dem Trägerelement und dem Target gleichzeitig herzustellen.

Alternativ oder zusätzlich können die Federelemente auch vor dem Aufschieben der Rohrsegmente auf das Trägerelement bereits stoffschlüssig mit dem Trägerelement verbunden werden. Auf diese Weise sind die Federelemerite am Trägerelement fixiert und können beim Aufschieben der Rohrsegmente auf das Trägerelement nicht in axialer Richtung verschoben werden. Der gleiche Effekt kann alternativ oder zusätzlich dadurch erreicht werden, dass in dem Trägerelement Aufnahmen für die Federelemente vorgesehen werden.

Um - wie voranstehend bereits beschrieben wurde - die Haftung des Lotes an dem Target bzw. dem Trägerelement zu verbessern, kann das Rohrsegment an seiner Innenseite und/oder das Trägerelement an seiner Außenseite vor dem Aufbringen des Lotes, insbesondere ganzflächig, metallisiert werden.

Weiterer Gegenstand der Erfindung ist außerdem ein Rohrsegment nach Anspruch 13.

Die Beschichtung kann z.B. eine Ni aufweisende Schicht, eine Cu aufweisende Schicht und eine SnPb aufweisende Schicht umfassen. Die Ni-Schicht verfügt über eine besonders gute Haftfestigkeit zu einem ZnO aufweisenden Keramikmaterial, während die Cu-Schicht die Ni-Schicht vor Korrosion schützt und die Porosität der SnPb-Schicht verringert. Die Cu-Schicht kann optional auch weggelassen werden. Bei der SnPb-Schicht handelt es sich um die eigentliche Funktionsschicht, welche für eine optimale Haftung eines flussmittelfreien Lotes an dem Rohrsegment sorgt.

Das Keramikmaterial, des Rohrsegements kann ITO (indium tin oxide) aufweisen.

Nachfolgend wird die Erfindung rein beispielhaft anhand vorteilhafter Ausführungsformen unter Bezugnahme auf die Zeichnung beschrieben. Es zeigen:
- Fig. 1: einen Längsschnitt durch eine erste Ausführungsform einer erfindungsgemäßen Targetanordnung in einem Vormontagezustand;
- Fig. 2: einen Längsschnitt durch die Targetanordnung von Fig. 1 während der Lot-Verflüssigung;
- Fig. 3: einen Längsschnitt durch die Targetanordnung von Fig. 1 in einem Endmontagezustand;
- Fig. 4: einen Querschnitt durch ein Targetrohrsegment der Targetanordnung von Fig. 1; und
- Fig. 5: einen Längsschnitt durch eine Targetanordnung in einem Endmontagezustand.

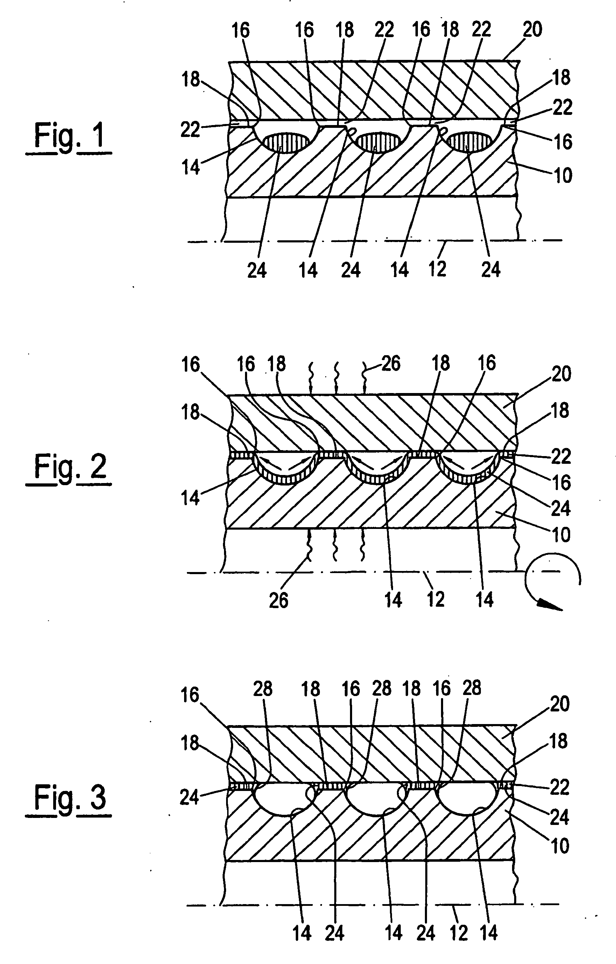

Die in Fig. 1 dargestellte erfindungsgemäße Targetanordnung umfasst ein rohrförmiges Trägerelement 10, welches ein metallisches Material aufweist, wie beispielsweise Titan, Stahl, insbesondere Edelstahl, oder Kupfer. Die strichpunktierte Linie 12 stellt die Längsmittelachse des Trägerelements 10 dar. An seiner Außenseite ist das Trägerelement 10 mit einer Lotschicht versehen, beispielsweise einer Schicht aus Lotzinn.

Ferner sind an der Außenseite des Trägerelements 10 mehrere nutartige Aussparungen 14 in das Trägerelement 10 eingebracht, beispielsweise eingefräst oder eingeschnitten. Bei dem dargestellten Ausführungsbeispiel weisen die Aussparungen 14 einen runden und insbesondere etwa halbkreisförmigen Querschnitt auf, doch können die Aussparungen 14 grundsätzlich auch einen nicht-teilkreisförmigen runden oder sogar einen eckigen Querschnitt aufweisen.

Ferner erstrecken sich die Aussparungen 14 bei dem dargestellten Ausführungsbeispiel quer zur Längsmittelachse 12, d.h. in Umfangsrichtung des Trägerelements 10, und zwar jeweils entlang des gesamten Umfangs des Trägerelements 10. Die Aussparungen 14 sind mit anderen Worten ringnutartig ausgebildet. Alternativ kann eine Aussparung auch spiralförmig, d.h. gewindenutartig, um das Trägerelement herum verlaufen. Es sind auch Mischformen denkbar, bei denen in axialer Richtung gesehen abschnittsweise mehrere Aussparungen 14 ringnutartig vorgesehen sind bzw. eine gewindenutartige Aussparung vorgesehen ist.

Wie in Fig. 1 gezeigt ist, sind die Aussparungen 14 derart zueinander beabstandet, dass durch zwei benachbarte Aussparungen 14 jeweils ein dazwischen liegender Vorsprung 16 gebildet ist. Entsprechend der Ausbildung der Aussparungen 14 erstrecken sich auch die Vorsprünge 16 in Umfangsrichtung, d.h. quer zur Längsmittelachse 12, entlang des gesamten Umfangs des Trägerelements 10. Im Falle einer gewindenutartigen Aussparung würde ein Vorsprung entsprechend spiralförmig um das Trägerelement herum verlaufen.

Die Abstände zwischen benachbarten Aussparungen 14 sind so gewählt, dass die Vorsprünge 16 an ihrer nach außen weisenden Oberseite 18 jeweils einen abgeflachten Plateaubereich 18 aufweisen. Die Breite des Plateaubereichs 18 kann dabei etwa die Hälfte der Breite der Aussparungen 14 betragen.

Wie in Fig. 1 dargestellt ist, umfasst die Targetanordnung ferner ein hohlzylindrisches Target 20 bestehend aus mindestens einem einstückig ausgebildeten Rohrsegment 21, welches ein Targetmaterial aufweist, insbesondere ein Keramikmaterial, wie z.B. ZnO.

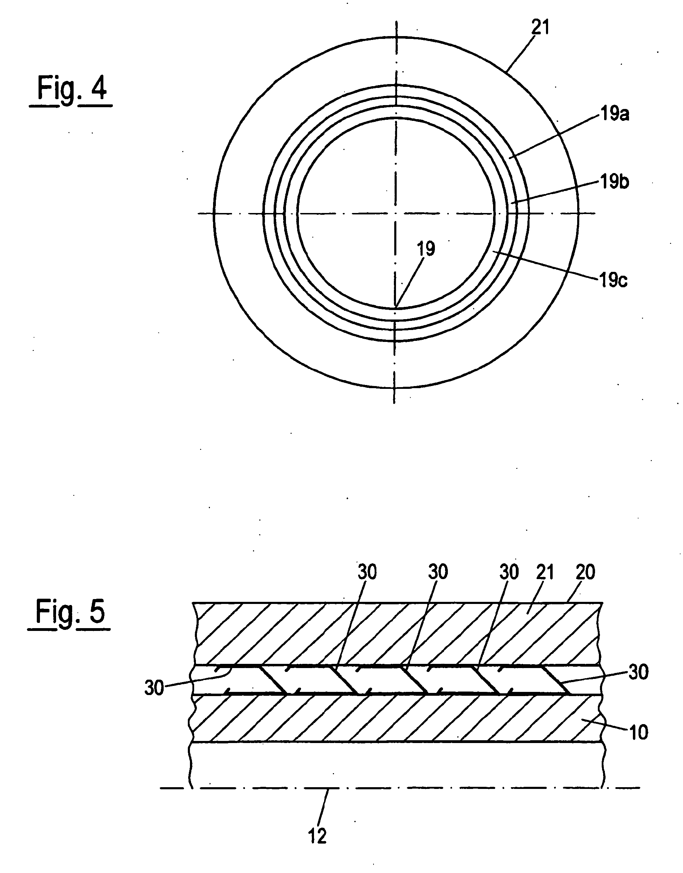

Jedes Rohrsegment 21 weist an seiner Innenseite eine metallische Beschichtung auf, beispielsweise eine galvanische Beschichtung 19 (Fig. 4). Die Beschichtung besteht aus drei aufeinander folgenden Schichten, nämlich einer inneren Schicht 19a aus Ni, einer mittleren Schicht 19b aus Cu und einer äußeren Schicht 19c aus SnPb, wobei die mittlere Schicht 19b aus Cu auch weggelassen werden kann.

Jedes Rohrsegement 21 umgibt das Trägerelement 10 zumindest abschnittsweise. Ist das Target 20 aus mehreren Rohrsegmenten 21 zusammengesetzt, so ist zwischen zwei benachbarten Rohrsegmenten 21 jeweils ein (nicht gezeigtes) hitzbeständiges Dichtmaterial vorgesehen, z.B. ein Silikonmaterial.

Der Innendurchmesser jedes Rohrsegments 21 ist derart an den Außendurchmesser des Trägerelements 10 im Bereich der Vorsprünge 16 angepasst, dass zwischen des Plateaubereich 18 jedes Vorsprungs 16 und der Innenseite des Rohrsegments 21 ein Spalt 22 ausgebildet ist. Im nicht erwärmten Zustand der Targetanordnung, d.h. beispielsweise bei Zimmertemperatur, können die Spalte 22 eine Spaltbreite aufweisen, die im Bereich von einigen Zehntel Millimetern liegt.

Zur Verbindung von Trägerelement 10 und Target 20 sind mehrere plastisch verformbare Ausgleichsmittel vorgesehen, welche bei dem in Fig. 1 bis 3 dargestellten Ausführungsbeispiel durch ein flussmittelfreies Weichlot 24 gebildet sind, das z.B. SnIn oder SnPb aufweist.

Zur Montage der Targetanordnung wird das Weichlot 24 in die Aussparungen 14 eingebracht, z.B. als Halbzeug in die Aussparungen 14 eingelegt. Anschließend werden das Rohrsegment 21 bzw. die Rohrsegmente 21 auf das Trägerelement 10 aufgeschoben und über den das Weichlot 24 aufnehmenden Aussparungen 14 positioniert.

Wie in Fig. 1 angedeutet ist, sind die Aussparungen 14 in axialer Richtung gesehen über im Wesentlichen die gesamte Länge des Targets 20 verteilt angeordnet. Zur Fixierung und Zentrierung des Targets 20 bezüglich des Trägerelements 10 in dem in Fig. 1 gezeigten Vormontagezustand sind nicht dargestellte Fixiermittel, beispielsweise Federelemente, in denjenigen Aussparungen 14 angeordnet, die sich im Bereich der axialen Enden des bzw. jedes Rohrsegments 21 befinden.

Zur stoffschlüssigen Verbindung des Targets 20 mit dem Trägerelement 10 wird das als Halbzeug in den Aussparungen 14 vorliegende Weichlot 24 mittels eines gezielten Wärmeeintrags 26 verflüssigt, wie es in Fig. 2 dargestellt ist. Die Erhitzung des Weichlotes 24 kann, beispielsweise in einem Durchlaufofen, von außen über das Target 20 und/oder mittels einer in das Trägerelement 10 einführbaren Wärmequelle von innen über das Trägerelement 10 erfolgen.

Beim Aufschmelzen des Weichlotes 24 erwärmen sich auch das Trägerelement 10 und das Target 20. Aufgrund dieser Erwärmung dehnen sich das Trägerelement 10 und das Target 20 unterschiedlich stark aus, wodurch sich die Breite der Spalte 22 zwischen den Vorsprüngen 16 des Trägerelements 10 und dem Rohrsegment 21 bzw. den Rohrsegmente 21 verringert, beispielsweise auf eine Spaltbreite von 0,05 mm bis 0,1 mm.

Zusätzlich zur Verflüssigung des Weichlotes 24 werden das Trägerelement 10 und das Target 20 gemeinsam in Rotation um die Längsmittelachse 12 versetzt. Die Rotation der Targetanordnung wird dabei so gewählt, dass sich das verflüssigte Weichlot 24 aufgrund von Zentrifugal- und Kapillarkräften aus den Aussparungen 14 heraus auf die Plateaubereiche 18 der Vorsprünge 16 bewegt und sich in und an den Spalten 22 zusammenzieht. Durch das Dichtmaterial zwischen benachbarten Rohrsegmenten 21 wird verhindert, dass aufgeschmolzenes Lot 24 an die Außenseite des Targets 20 gelangen kann.

Die Erwärmung und die Rotation der Targetanordnung werden so lange aufrechterhalten, bis sich so viel Lot 24 in den Spalten 22 angesammelt hat, dass diese vollständig mit Lot 24 ausgefüllt sind. Das Lot 24 steht nunmehr sowohl mit den Plateaubereichen 18 der Vorsprünge 16 des Trägerelements 10 als auch mit dem Target 20 in Kontakt und überbrückt somit den Zwischenraum zwischen Target 20 und Trägerelement 10.

Anschließend wird die Wärmezufuhr 26 beendet, so dass die Targetanordnung, vorzugsweise unter fortgesetzter Rotation, abkühlen kann. Aufgrund dieser Abkühlung erstarrt das Weichlot 24, wobei es sich gleichzeitig stoffschlüssig mit dem Target 20 und dem Trägerelement 10 verbindet.

Infolge der unterschiedlichen Wärmedehnungen von Target 20 und Trägerelement 10 vergrößert sich der Abstand zwischen Target 20 und Trägerelement 10 beim Abkühlen der Targetanordnung wieder. Wie in Fig. 3 dargestellt ist, wird das in den Spalten 22 befindliche Weichlot 24 dabei unter Bildung von Lotbrücken bzw. Lötkehlen 28 auseinander gezogen. Durch die plastische Verformbarkeit der Lötkehlen 28 werden Spannungen in dem Target 20 vermieden, die aufgrund der unterschiedlichen Wärmedehnung der Fügepartner 10, 20 während des Abkühlens in dem Target 20 auftreten und zu einer Beschädigung des Targets 20 führen könnten.

Das Ergebnis ist eine Targetanordnung, deren Target 20 über die plastisch verformbaren Lötkehlen 28 aus Weichlot 24 stoffschlüssig mit dem Trägerelement 10 verbunden ist. Dadurch wird zum einen eine besonders gute thermische Ankopplung des Targets 20 an das Trägerelement 10 und zum anderen eine zuverlässige mechanische Befestigung des Targets 20 an dem Trägerelement 10 erreicht, ohne dass dabei die Gefahr einer BeSchädigung des Targets 20 aufgrund von Spannungen besteht, die aus der unterschiedlichen Wärmedehnung der Fügepartner resultieren könnten.

Bei der in Fig. 5 dargestellten zur Erfindung alternativen Ausführungsform sind das aus einem oder mehreren Rohrsegmenten 21 gebildete Target 20 und das Trägerelement 10 nicht durch Lötkehlen 24 miteinander verbunden. Stattdessen wird die unterschiedlich starke Ausdehnung von Trägerelement 10 und Target 20 bei Erwärmung der Targetanordnung, z.B. während eines Sputtervorgangs, durch Federelemente 30 kompensiert, die zwischen dem Trägerelement 10 und dem Rohrsegment 21 bzw. den Rohrsegmenten 21 angeordnet sind. Die Federelemente 30 bilden die Ausgleichsmittel dieser Ausführungsform, indem sie bei einer Erwärmung der Targetanordnung komprimiert werden und bei einer Abkühlung der Targetanordnung wieder expandieren.

Um einen besonders guten Wärmeübergang von dem Target 20 über die Federelemente 30 auf das Trägerelement 10 zu gewährleisten, sind die Federelemente 30 stoffschlüssig sowohl mit dem Rohrsegment 21 bzw. den Rohrsegmenten 21 als auch mit dem Trägerelement 10 verbunden.

Als Verbindungsmittel ist ein Weichlot vorgesehen, das zwischen die Federelemente 30 und das Rohrsegment 21 bzw. die Rohrsegmente 21 sowie zwischen die Federelemente 30 und das Trägerelement 10 eingebracht ist. Durch einen entsprechenden Aufschmelz- und Abkühlungsvorgang wird jeweils eine stoffschlüssige Verbindung zwischen den Federelementen 30 und dem Trägerelement 10 bzw. dem Target 20 hergestellt.

Wie bei der voranstehend beschriebenen ersten Ausführungsform ist auch bei dieser Ausführungsform eine metallische Beschichtung 19, umfassend eine Ni-Schicht 19a, eine optionale Cu-Schicht 19b und eine SnPb-Schicht 19c, an der Innenseite jedes Rohrsegments 21 vorgesehen (Fig. 4), um die stoffschlüssige Verbindung von Weichlot und Target 20 zu verbessern. Entsprechend ist das Trägerelement 10 an seiner Außenseite mit einer Lotschicht versehen, beispielsweise einer Schicht aus Lotzinn.

Die Befestigung der Federelemente 30 mit dem Trägerelement 10 kann gleichzeitig mit der Befestigung der Federelemente 30 mit dem Target 20 erfolgen.

Alternativ oder zusätzlich können die Federelemente 30 auch vor dem Aufschieben des Rohrsegments 21 bzw. der Rohrsegmente 21 auf das Trägerelement 10 stoffschlüssig mit dem Trägerelement 10 verbunden werden. Auf diese Weise sind die Federelemente 30 bereits bei der Montage des Targets 20 an dem Trägerelement 10 fixiert und gegen eine axiale Verschiebung durch das Rohrsegment 21 bzw. die Rohrsegmente 21 gesichert. Alternativ oder zusätzlich können die Federelemente 30 zu diesem Zweck auch in (nicht gezeigten) Aussparungen des Trägerelements 10 gelagert sein.

### Bezugszeichenliste

- 10: Trägerelement
- 12: Längsmittelachse
- 14: Aussparung
- 16: Vorsprung
- 18: Plateaubereich
- 19: Beschichtung
- 20: Target
- 22: Spalt
- 24: Weichlot
- 26: Wärmeeintrag
- 28: Lötkehle
- 30: Federelement

## Patentansprüche

1. Targetanordnung mit einem rohrförmigen Trägerelement (10) und einem mindestens ein Targetmaterial aufweisenden hohlzylindrischen Target (20), welches wenigstens ein einstückig ausgebildetes und das Trägerelement (10) zumindest abschnittsweise umgebendes Rohrsegment (21) umfasst, wobei das Trägerelement (10) und das Rohrsegment (21) durch wenigstens zwei plastisch verformbare Ausgleichsmittel partiell stoffschlüssig miteinander verbunden sind,
**dadurch gekennzeichnet,**
**dass** zueinander beabstandete Bereiche (22) eines zwischen dem Target (20) und dem Trägerelement (10) vorgesehenen Zwischenraums mit Lot (24), insbesondere Weichlot, ausgefüllt sind.

2. Targetanordnung nach Anspruch 1,
**dadurch gekennzeichnet,**
**dass** das Lot (24) zwischen dem Target (20) und Vorsprüngen (16) des Trägerelements (10) vorgesehen ist, wobei die Vorsprünge (16) bevorzugt in axialer oder radialer Richtung gesehen zueinander beabstandet sind und insbesondere über die in radialer oder axialer Richtung gesehen im Wesentlichen gesamte Länge des Targets (20) verteilt angeordnet sind.

3. Targetanordnung nach Anspruch 2,
**dadurch gekennzeichnet,**
**dass** die Vorsprünge (16) im Wesentlichen in Umfangsrichtung des Trägerelements (10) verlaufende Stege umfassen und/oder dass sich mehrere stegartige Vorsprünge (16) rechtwinklig zur Längsachse (12) des Trägerelements (10) erstrecken und/oder dass ein stegartiger Vorsprung spiralförmig um das Trägerelement (10) herum verläuft.

4. Targetanordnung nach Anspruch 2 oder 3,
**dadurch gekennzeichnet,**
**dass** durch die Vorsprünge (16) begrenzte Aussparungen (14) des Trägerelements (10) in einem Vormontagezustand der Targetanordnung einen Aufnahmeraum für das Lot (24) bilden.

5. Targetanordnung nach einem der vorherigen Ansprüche,
**dadurch gekennzeichnet,**
**dass** Fixiermittel zwischen dem Rohrsegment (21) und dem Trägerelement (10) angeordnet sind, um das Target (20) in einem Vormontagezustand bezüglich des Trägerelements (10) zu fixieren und insbesondere zu zentrieren.

6. Targetanordnung nach einem der vorherigen Ansprüche,
**dadurch gekennzeichnet,**
**dass** das Rohrsegment (21) an seiner Innenseite und/oder das Trägerelement (10) an seiner Außenseite, insbesondere ganzflächig, metallisiert, z.B. belotet, ist.

7. Targetanordnung nach einem der vorherigen Ansprüche,
**dadurch gekennzeichnet,**
**dass** die Ausgleichsmittel in axial zueinander beabstandeten Bereichen (22) zwischen dem Rohrsegment (21) und dem Trägerelement (10) angeordnet sind und/oder dass die Ausgleichsmittel flussmittelfrei sind.

8. Targetanordnung nach einem der vorherigen Ansprüche,
**dadurch gekennzeichnet,**
**dass** zwischen zwei benachbarten Rohrsegmenten (21) jeweils ein, insbesondere hitzbeständiges, Dichtmaterial, z.B. ein Silikonmaterial, vorgesehen ist.

9. Verfahren zur Herstellung einer Targetanordnung mit einem rohrförmigen Trägerelement (10) und einem mindestens ein Targetmaterial aufweisenden hohlzylindrischen Target (20), welches wenigstens ein einstückig ausgebildetes und das Trägerelement (10) zumindest abschnittsweise umgebendes Rohrsegment (21) umfasst, bei welchem Verfahren das Trägerelement (10) und das Rohrsegment (21) durch wenigstens zwei plastisch verformbare Ausgleichsmittel partiell stoffschlüssig miteinander verbunden werden,
**dadurch gekennzeichnet ,**
**dass** zueinander beabstandete Bereiche (22) eines zwischen dem Target (20) und dem Trägerelement (10) vorgesehenen Zwischenraums mit Lot (24) ausgefüllt werden.

10. Verfahren nach Anspruch 9,
**dadurch gekennzeichnet,**
**dass** das Trägerelement (10) und jedes Rohrsegment (21) mittels eines Lotes (24), insbesondere eines Weichlotes und bevorzugt mittels eines flussmittelfreien Weichlotes, miteinander verbunden werden.

11. Verfahren nach Anspruch 10,
**dadurch gekennzeichnet ,**
**dass** das Lot (24) in einem Vormontagezustand der Targetanordnung zwischen zueinander beabstandeten und insbesondere stegartig ausgebildeten Vorsprüngen (16) des Trägerelements (10) angeordnet wird und/oder dass das Lot (24) durch einen gezielten Wärmeeintrag (26) verflüssigt wird und das Target (20) und das Trägerelement (10) derart rotiert werden, dass sich das verflüssigte Lot (24) unter Einwirkung von Zentrifugal- und Kapillarkräften in zwischen dem Target (20) und Vorsprüngen (16) des Trägerelements (10) ausgebildete Spalte (22) hineinbewegt, um das Target (20) und das Trägerelement (10) zu kontaktieren.

12. Verfahren nach einem der Ansprüche 9 bis 11,
**dadurch gekennzeichnet ,**
**dass** das Rohrsegment (21) an seiner Innenseite und/oder das Trägerelement (10) an seiner Außenseite vor dem Aufbringen des Lotes, insbesondere ganzflächig, metallisiert, z.B. belotet, wird.

13. Rohrsegment (21) eines hohlzylindrischen Targets (20), aufweisend ein Keramikmaterial und eine, insbesondere vollflächige, metallische Beschichtung (19) an der Innenseite des Rohrsegments (21),
**dadurch gekennzeichnet,**
**dass** die Beschichtung (19) eine Schichtfolge von mindestens zwei Schichten (19a, 19c) aus unterschiedlichen Metallmaterialien umfasst, wobei eine äußere Schicht (19c) SnPb aufweist.

14. Rohrsegment (21) nach Anspruch 13,
**dadurch gekennzeichnet,**
**dass** das Keramikmaterial ZnO und/oder ITO aufweist und/oder dass die Beschichtung (19) eine innere Schicht (19a) umfasst, die Ni aufweist.

15. Rohrsegment (21) nach Anspruch 13 oder 14,
**dadurch gekennzeichnet,**
**dass** die Beschichtung (19) eine Schichtfolge von drei Schichten (19a, 19b, 19c) aus unterschiedlichen Metallmaterialien umfasst und insbesondere eine innere Schicht (19a), die Ni aufweist, eine mittlere Schicht (19b), die Cu aufweist, und die äußere Schicht (19c) umfasst, die SnPb aufweist.

## Claims

1. A target arrangement comprising a tubular carrier member (10) and a hollow cylindrical target (20) which comprises at least one target material and which includes at least one tube segment (21) made in one piece and surrounding the carrier member (10) at least section-wise, with the carrier member (10) and the tube segment (21) being partially connected to one another with material continuity by at least two plastically deformable compensation means (24, 30),
**characterized in that**
mutually spaced apart regions (22) of an intermediate space provided between the target (20) and the carrier member (10) are filled with solder (24).

2. A target arrangement in accordance with claim 1, **characterized in that** the solder (24) is provided between the target (20) and projections (16) of the carrier member (10), the projections (16) preferably being spaced apart from one another, viewed in the axial or radial direction, and in particular being arranged distributed over substantially the total length of the target (20), viewed in the radial or axial direction.

3. A target arrangement in accordance with claim 2, **characterized in that** the projections (16) comprise webs substantially extending in the peripheral direction of the carrier member (10); and/ **in that** a plurality of web-like projections (16) extend at right angles to the longitudinal axis (12) of the carrier member (10); and/or **in that** a web-like projection extends in a spiral manner around the carrier member (10).

4. A target arrangement in accordance with claim 2 or claim 3, **characterized in that** cut-outs (14) of the carrier member (10) bounded by the projections (16) form a receiving space for the solder (24) in a pre-assembly state of the target arrangement.

5. A target arrangement in accordance with any one of the preceding claims, **characterized in that** fixing means are arranged between the tube segment (21) and the carrier member (10) to fix, and in particular to center, the target (20) with respect to the carrier member (10) in a pre-assembly state.

6. A target arrangement in accordance with any one of the preceding claims, **characterized in that** the tube segment (21) is metallized, e.g. solder coated, in particular over the full area, at its inner side and/or the carrier member (10) is metallized, e.g. solder coated, in particular over the full area, at its outer side.

7. A target arrangement in accordance with any one of the preceding claims, **characterized in that** the compensation means (24, 30) are arranged in regions (22) axially spaced apart from one another between the tube segment (21) and the carrier member (10); and/or in that the compensation means are free of flux.

8. A target arrangement in accordance with any one of the preceding claims, **characterized in that** a respecting sealing material, in particular a heat-resistant sealing material, e.g. a silicone material, is provided between two adjacent tube segments (21).

9. A method for the manufacturing of a target arrangement comprising a tubular carrier member (10) and a hollow cylindrical target (20) which comprises at least one target material and which includes at least one tube segment (21) made in one piece and surrounding the carrier member (10) at least section-wise, in which method the carrier member (10) and the tube segment (21) are partially connected to one another with material continuity by at least two plastically deformable compensation means,
**characterized in that**
mutually spaced apart regions (22) of an intermediate space provided between the target (20) and the carrier member (10) are filled with solder (24).

10. A method in accordance with claim 9, **characterized in that** the carrier member (10) and each tube segment (21) are connected to one another by means of a solder (24), in particular of a soft solder, and preferably by means of a soft solder free of flux.

11. A method in accordance with claim 10, **characterized in that** the solder (24) is arranged between projections (16) of the carrier member (10) spaced apart from one another and in particular made in the manner of webs in a pre-assembly state of the target arrangement; and/or **in that** the solder (24) is liquefied by a direct heat input (26) and the target (20) and the carrier member (10) are rotated such that the liquefied solder (24) moves under the effect of centrifugal forces and capillary forces into gaps (22) formed between the target (20) and projections (16) of the carrier member (10) to contact the target (20) and the carrier member (10).

12. A method in accordance with any one of the claims 9 to 11, **characterized in that** the tube segment (21) is metallized, e.g. solder plated, in particular over the full area, at its inner side and/or the carrier member (10) is metallized, e.g. solder plated, in particular over the full area, at its outer side before the application of the solder.

13. A tube segment (21) of a hollow cylindrical target (20), comprising a ceramic material and a metal coating (19), in particular a full area metal coating, at the inner side of the tube segment (21), **characterized in that** the coating (19) includes a layer sequence of at least two layers (19a, 19c) made of different metal materials, with an outer layer (19c) comprising SnPb.

14. A tube segment (21) in accordance with claim 13, **characterized in that** the ceramic material comprises ZnO and/or ITO; and/or **in that** the coating (19) includes an inner layer (19a) which comprises Ni.

15. A tube segment (21) in accordance with claim 13 or claim 14, **characterized in that** the coating (19) includes a layer sequence of three layers (19a, 19b, 19c) made of different metal materials, and in particular includes an inner layer (19a) comprising Ni, a middle layer (19b) comprising Cu and the outer layer (19c) comprising SnPb.

## Revendications

1. Système de cible comprenant un élément porteur (10) de forme tubulaire et une cible (20) cylindrique creuse présentant au moins un matériau cible, laquelle comprend au moins un segment tubulaire (21) réalisé d'un seul tenant et entourant l'élément porteur (10) au moins localement, dans lequel l'élément porteur (10) et le segment tubulaire (21) sont reliés l'un à l'autre partiellement en coopération de matières via au moins deux organes de compensation plastiquement déformables,
**caractérisé en ce que**
des régions (22) mutuellement écartées d'un intervalle prévu entre la cible (20) et l'élément porteur (10) sont remplies d'un agent de brasage (24), en particulier d'un agent de brasage tendre.

2. Système de cible selon la revendication 1,
**caractérisé en ce que** l'agent de brasage (24) est prévu entre la cible (20) et des saillies (16) de l'élément porteur (10), lesdites saillies (16) étant écartées les unes des autres de préférence en direction axiale ou radiale, et étant agencées de façon répartie en particulier sensiblement sur la totalité de la longueur de la cible (20), vue en direction radiale ou axiale.

3. Système de cible selon la revendication 2,
**caractérisé en ce que** les saillies (16) comprennent des barrettes qui s'étendent sensiblement en direction périphérique de l'élément porteur (10), et/ou **en ce que** plusieurs saillies (16) semblables à des barrettes s'étendent à angle droit par rapport à l'axe longitudinal (12) de l'élément porteur (10) et/ou **en ce qu'**une saillie semblable à une barrette s'étend en forme de spirale tout autour de l'élément porteur (10).

4. Système de cible selon la revendication 2 ou 3,
**caractérisé en ce que** des évidements (14), délimités par les saillies (16), de l'élément porteur (10) forment un espace de réception pour l'agent de brasage (24), dans une situation de prémontage du système de cible.

5. Système de cible selon l'une des revendications précédentes,
**caractérisé en ce que** des organes de fixation sont agencés entre le segment tubulaire (21) et l'élément porteur (10), afin de fixer la cible (20) par rapport à l'élément porteur (10) dans une situation de prémontage, et en particulier de la centrer.

6. Système de cible selon l'une des revendications précédentes,
**caractérisé en ce que** le segment tubulaire (21) est métallisé sur sa face intérieure et/ou **en ce que** l'élément porteur (10) est métallisé sur sa face extérieure, en particulier sur toute leur surface, par exemple par brasage.

7. Système de cible selon l'une des revendications précédentes,
**caractérisé en ce que** les organes de compensation sont agencés entre le segment tubulaire (21) et l'élément porteur (10) dans des régions (22) écartées axialement l'une de l'autre, et/ou **en ce que** les organes de compensation sont dépourvus de flux.

8. Système de cible selon l'une des revendications précédentes,
**caractérisé en ce qu'**il est prévu un matériau d'étanchement respectif, en particulier résistant à la chaleur, comme par exemple un matériau à base de silicone, entre deux segments tubulaires voisins (21).

9. Procédé pour la réalisation d'un système de cible comprenant un élément porteur (10) de forme tubulaire et une cible (20) cylindrique creuse qui comprend au moins un matériau de cible, laquelle comprend au moins un segment tubulaire (21) réalisé d'un seul tenant et entourant l'élément porteur (10) au moins localement, procédé dans lequel l'élément porteur (10) et le segment tubulaire (21) sont reliés l'un à l'autre partiellement en coopération de matières via au moins deux organes de compensation plastiquement déformables,
**caractérisé en ce que** des régions mutuellement écartées (22) d'un espace intermédiaire prévu entre la cible (20) et l'élément porteur (10) sont remplies d'un agent de brasage (24).

10. Procédé selon la revendication 9,
**caractérisé en ce que** l'élément porteur (10) et chaque segment tubulaire (21) sont reliés l'un à l'autre au moyen d'un agent de brasage (24), en particulier d'un agent de brasage tendre, et de façon préférée au moyen d'un agent de brasage tendre exempt de flux.

11. Procédé selon la revendication 10,
**caractérisé en ce que**, dans une situation de prémontage du système de cible, l'agent de brasage (24) est agencé entre des saillies (16) de l'élément porteur (10), écartées les unes des autres et réalisées en particulier en forme de barrettes, et/ou **en ce que** l'agent de brasage (24) est rendu liquide par rapport de chaleur ciblée (26) et la cible (20) et l'élément porteur (10) sont mis en rotation de telle façon que l'agent de brasage (24) liquéfié se déplace sous l'effet de forces centrifuges et de forces capillaires pour rentrer dans des fentes (22) réalisées entre la cible (20) et les saillies (16) de l'élément porteur (10), afin d'établir un contact entre la cible (20) et l'élément porteur (10).

12. Procédé selon l'une des revendications 9 à 11,
**caractérisé en ce que** le segment tubulaire (21) est métallisé sur sa face intérieure et/ou **en ce que**, avant l'application de l'agent de brasage, l'élément porteur (10) est métallisé sur sa face extérieure, en particulier sur toute leur surface, par exemple par brasage.

13. Segment tubulaire (21) une cible (20) cylindrique creuse, comprenant un matériau céramique et un revêtement métallique (19), en particulier sur toute la surface, sur la face intérieure du segment tubulaire (21),
**caractérisé en ce que** le revêtement (19) comprend une suite de couches formées d'au moins deux couches (19a, 19c) en matériaux métalliques différents, dans lesquels une couche extérieure (19c) comprend du SnPb.

14. Segment tubulaire (21) selon la revendication 13,
**caractérisé en ce que** le matériau céramique comprend ZnO et/ou ITO, et/ou **en ce que** le revêtement (19) comprend une couche intérieure (19a) qui comprend du Ni.

15. Segment tubulaire (21) selon la revendication 13 ou 14,
**caractérisé en ce que** le revêtement (19) comprend une suite de couches formées de trois couches (19a, 19b, 19c) en matériaux métalliques différents, et en particulier une couche intérieure (19a) qui comprend Ni, une couche médiane (19b) qui comprend Cu, et la couche extérieure (19c) qui comprend SnPb.
